# EUROPEAN PATENT SPECIFICATION

(11) **EP 3 291 312 B1**
(45) Date of publication and mention of the grant of the patent: **05.11.2025**
(21) Application number: 16186799.9
(22) Date of filing: 01.09.2016
(51) Int. Cl.: H10F 19/00, E04H 15/02, E04H 15/10, E04H 15/34, H02S 30/10, H02S 20/30, H02S 40/38, H02S 40/42

(54) **SOLAR TENT**
SOLARZELT
TENTE SOLAIRE

(43) Date of publication of application: 07.03.2018
(73) Proprietor: Yotrio Group Co., Ltd., Linhai City Zhejiang 317004 (CN)
(72) Inventor: XIE, Jianping, 317007 Linhai Zhejiang (CN)
(74) Representative: Schulz Junghans Patentanwälte PartGmbB

(56) References cited:
- WO-A1-2016/109562
- DE-A1- 102005 033 777
- DE-U1- 202010 010 065
- DE-U1- 202012 011 438
- US-A1- 2007 022 669
- US-A1- 2011 005 560
- US-A1- 2011 023 931
- US-A1- 2013 169 047
- US-A1- 2013 276 382

## Description

The invention relates to a solar tent based on a power supply system, equipped with an integrated chip platform and applying modular electronic components.

Particularly, the invention relates to a product that is based on independent solar energy (Silicon, thin film photovoltaic, etc.) power supply system, equipped with an integrated chip platform and applying modular electronic components, with the help of a circuit and electronic process control it can achieve gradual change atmospheric lighting, additional lighting, Bluetooth speaker, USB port charging, cooling and heating device and various other intelligent functions in the field of electronics. This achieves the standardization of outdoor products and electronic functions, and it can be applied on all current tent products. This particular tent product which only implemented lighting, Bluetooth speaker, USB port, cooling and heating smart function

By means of a circuit and electronic process control the solar tent can achieve a gradual change in atmospheric lighting, and may comprise additional lighting, Bluetooth speakers, a port for charging electronic devices, a cooling and heating device and various other intelligent functions in the field of electronics. This achieves the standardization of outdoor products and electronic functions. The invention can be applied on all current tent products. The special features of the invention are: a solar panel applied to a tent top part applied, a unique lighting system which includes lights and atmospheric lighting, as well as cold and warm lighting, wherein the lighting system is positioned inside the tent. The tent leg part possesses a Bluetooth speaker system and a USB port, which can receive smart phone signals and charge smart phones. A cooling and heating system which can adjust the temperature inside the tent is comprised in the upper part of the tent.

Due to rapid economic development and improved standards of living, people have higher expectations in terms of living quality, thus the application of tents is becoming more common and frequent in the fields of entertainment and pleasure.

Although currently there are various types of tents on the market, their functions are limited to conventional use such as keeping out sunshine, wind or rain. The functions of the tents have not been intensively developed, for instance, it would be difficult to use tents at night without lighting, or when the weather is too warm or too cold, and the user will have to separately provide a set of speakers while considering power supply if they wish to listen to music.

An example of a known tent with a solar panel is disclosed in DE 10 2005 033 777 A1.

Therefore, the problem to be solved by the present invention is to provide an improved tent having additional functions.

This problem is solved by the solar tent according to the independent claim 1. The dependent claims 2 to 15 relate to embodiments of the solar tent, which are described hereafter.

The solar tent according to the invention comprises a lower top plate, an upper top plate, at least one lower top tube, at least one upper top tube, a top frame, at least one horizontal tube, particularly at least one top horizontal tube, at least one side tube, at least one ring beam, particularly at least one ring beam part, at least one leg tube, particularly at least one leg tube part, a battery box, at least one solar panel, at least one lighting tube, a Bluetooth speaker component, a temperature control device, particularly a heating and/ or cooling device, more particularly a cooling and heating component, a switchbox, and a USB port.

The described solar panel is able to provide high power supply and is able to keep off sunshine as well as rain. The described input circuit from the solar panel to the battery box, the output circuit from the battery box to all kinds of electronic devices and the switch can be installed inside the tube part, and the described lighting tube can be fixed on the lower side of the lower top tube. The combination of the described upper top tube and lower top tube can hide the circuit and avoid water from entering.

In the invention, the top part of the solar tent comprises the solar panel, the at least one top tube, the top frame, and the top plate.

In the invention, the USB port is integrated in the switchbox.

In the invention, the Bluetooth speaker and switchbox are inserted in the at least one leg tube, particularly thereby composing the leg tube part.

In certain embodiments, the cooling and heating component is inserted in the ring beam, particularly thereby composing the ring beam part.

In certain embodiments, the battery box is fixed on the lower side of the lower top plate, particularly thereby composing the lower top plate part.

In certain embodiments, the lower top plate part comprises a spring plug-in, which coordinates the lower top tube and upper top tube.

In certain embodiments, the described lower top plate part comprises a top plate connection device for mechanically connecting the lower top plate to the upper top plate, wherein the top plate connection device particularly combines the upper top plate.

In certain embodiments, the lower top plate part comprises a first lower top plate upright circuit connection device, which is adapted to be electrically connected to the at least one lighting tube, particularly is electrically connected to the at least one lighting tube..

In certain embodiments, the lower top plate part comprises a first lower top plate reverse side circuit connection device, which is adapted to be electrically connected to the at least one solar panel, particularly is electrically connected to the at least one solar panel.

In certain embodiments, the lower top plate part comprises a second lower top plate upright circuit connection device, which is adapted to be electrically connected to the switchbox, particularly is electrically connected to the switchbox.

In certain embodiments, the upper top plate comprises a first upper top plate hole for mechanically connecting the upper top plate to the lower top plate, wherein particularly the upper top plate hole coordinates with the lower top plate part.

In certain embodiments, the at least one lower top tube comprises a first tube and first lower top tube hole, which coordinate with the lower top plate.

In certain embodiments, both sides of the described lower top tube comprise a gutter, wherein the gutter comprises a second hole which is combined with the solar panel.

In certain embodiments, the at least one lower top tube comprises a cable slot, wherein the cable slot comprises a third hole, which coordinates with the at least one upper top tube, and a circuit which connects the battery box to the switchbox, wherein both ends of the circuit comprise second lower top tube reverse circuit connection devices.

In certain embodiments, the lower top tube part's lower end comprises a fourth hole, which is combined with the at least one ring beam.

In certain embodiments, the lower top tube part's lower end comprises a fifth hole, which is combined with the at least one side tube.

In certain embodiments, the lower top tube's lower side comprises a sixth hole, which coordinates with the at least one lighting tube.

In certain embodiments, the at least one lower top tube comprises a second tube which coordinates with the top frame.

In certain embodiments, the at least one upper top tube comprises side wings, which are adapted to cover the lower top tube.

In certain embodiments, the at least one upper top tube comprises a first tube which coordinates with the lower top plate, wherein the first tube comprises a first upper top tube hole which coordinates with the at least one lower top tube.

In certain embodiments, the top frame comprises top frame spring plug-in and an inbuilt plug-in which coordinate with the lower top tube part.

In certain embodiments, both sides of the at least one horizontal tube comprise card slots which coordinate with the at least one solar panel.

In certain embodiments, one side of the side tube comprises a card slot which coordinates with the at least one solar panel.

In certain embodiments, the at least one side tube comprises a first side tube hole which is combined with the at least one lower top tube part.

In certain embodiments, the at least one solar panel comprises a first solar panel upright circuit connection device which is connected to the battery box.

In certain embodiments, the at least one solar panel comprises a first solar panel hole which is combined with the at least one lower top tube.

In certain embodiments, the at least one lighting tube comprises a first lighting tube reverse side circuit connection device, which is connected to the battery box.

In certain embodiments, the at least one lighting tube comprises a first lighting tube hole which coordinates with the at least one lower top tube.

In certain embodiments, the at least one lighting tube comprises side wings which can be fixed to the top frame.

In certain embodiments, the at least one ring beam comprises a first ring beam hole, which is combined with the at least one lower top tube.

In certain embodiments, the at least one ring beam comprises a second hole, which is combined with the at least one leg tube.

In certain embodiments, the ring beam part comprises a first ring beam upright circuit connection device controlling the cooling and heating component.

In certain embodiments, the at least one leg tube comprises a first leg tube hole which coordinates the at least one ring beam.

In certain embodiments, the at least one leg tube part comprises a second leg tube upright circuit connection device, which is combined with the second lower top tube reverse side circuit connection device.

In certain embodiments, the at least one leg tube part comprises a first leg tube reverse side circuit connection device which is connected to the cooling and heating component.

In comparison with the state of the art, the present invention particularly comprises the following features. Firstly, the solar tent comprises a tent top part with a solar panel, which shall be regarded as a hard top tent. Thus, the tent is solid enough to withstand terrible weather such as heavy shower, snow and storm. Secondly, the tent top part possesses a solar panel which ensures the power supply for many electronic devices. This allows the tent's functions to be further developed, for instance the features described herein, particularly cooling and heating system, Bluetooth speakers system, USB port, and lighting system.

According to an aspect of the invention, a solar tent is provided, wherein the solar tent comprises at least one ring beam part, and at least one leg tube part, wherein the at least one leg tube part, particularly the upper end of the at least one leg tube part, is mechanically connected to a neighboring ring beam part, particularly a respective end of a neighboring ring beam part, more particularly two neighboring ring beam parts, at least one lower top tube and a top frame, wherein the at least one lower top tube is mechanically connected to the top frame and/ or the at least one ring beam part, a lower top plate, which is mechanically connected to the at least one lower top tube, an upper top plate , which is mechanically connected the lower top plate , particularly to an upper side of the lower top plate, wherein particularly the upper top plate surrounds the mechanical connections between the lower top plate and the lower top tubes , at least one solar panel, at least one horizontal tube, and at least one side tube, wherein the at least one solar panel is mechanically connected, particularly laterally, to at least one respective lower top tube, particularly two respective lower top tubes, and wherein the at least one solar panel is mechanically connected to a respective horizontal tube or to a respective side tube particularly at its lower end, wherein particularly pairs of neighboring solar panels are mechanically connected to each other by means of a respective horizontal tube, at least one upper top tube, which is mechanically connected to the at least one lower top tube, particularly to the upper side of the at least one lower top tube, wherein particularly the at least one upper top tube surrounds one side of a respective solar panel, a battery box, which is comprised in, particularly installed on, the lower top plate, wherein the battery box is adapted to be charged by the at least one solar panel, a Bluetooth speaker component, which is comprised in, particularly inserted into, the at least one leg tube, wherein the Bluetooth speaker component is electrically connected to the at least one solar panel and/ or the battery box, particularly by means of a circuit , wherein the at least one solar panel and/ or the battery box are adapted to provide electricity for operation of the Bluetooth speaker component, a switchbox, which is comprised in, particularly inserted into, the at least one leg tube, wherein the switchbox is electrically connected to the battery box, and wherein the switchbox comprises a USB port, which is comprised in, particularly integrated in, the switchbox, and wherein particularly the switchbox is adapted to control the circuit, a temperature control device, particularly a heating device and/ or a cooling device, wherein the temperature control device is comprised in, particularly inserted into, the at least one ring beam, and wherein the temperature control device is electrically connected to the at least one solar panel and/ or the battery box, particularly by means of a circuit, wherein the at least one solar panel and/ or the battery box are adapted to provide electricity for operation of the temperature control device, at least one lighting tube, which is mechanically connected to the lower top tube, particularly to the lower side of the lower top tube, and/ or wherein the lighting tube is mechanically connected to the top frame, and wherein the lighting tube is electrically connected to the at least one solar panel and/ or the battery box, wherein the at least one solar panel and/ or the battery box are adapted to provide electricity for operation of the at least one lighting tube.

In certain embodiments, the lower top plate comprises a lower top plate spring plug-in for mechanically connecting the lower top plate to the at least one lower top tube and/or the at least one upper top tube.

In certain embodiments, the lower top plate comprises a top plate connection device for mechanically connecting the lower top plate to the upper top plate.

In certain embodiments, the lower top plate comprises a first top plate upright circuit connection device, which is adapted to be electrically connected to the at least one lighting tube, and/ or a first top plate reverse side connection device, which is adapted to be electrically connected to the at least one solar panel, and/ or a second top plate upright connection device, which is particularly adapted to be connected to the at least one lower top tube.

In certain embodiments, the upper top plate comprises a first upper top plate hole for mechanically connecting the upper top plate to the lower top plate.

In certain embodiments, the at least one lower top tube comprises a gutter comprising a second hole for mechanically connecting the at least one solar panel to the gutter and/ or a cable slot comprising a third hole for mechanically connecting the at least one upper top tube to the cable slot, and/ or a circuit for electrically connecting the battery box to the switchbox, wherein the circuit comprises at least one second lower top tube reverse side connection device , particularly at both ends of the circuit, and/ or a fourth hole for mechanically connecting the at least one lower top tube to the at least one ring beam, and/ or a fifth hole for mechanically connecting the at least one lower top tube to the at least one side tube, and/ or a sixth hole for mechanically connecting the at least one lower top tube to the at least one lighting tube.

In certain embodiments, the upper top tube comprises at least one side wing, which is adapted to cover the at least one lower top tube.

In certain embodiments, the at least one upper top tube comprises a first tube, for mechanically connecting the at least one upper top tube to the lower top plate, wherein the first tube comprises a first upper top tube hole for mechanically connecting the at least one upper top tube to the at least one lower top tube.

In certain embodiments, the top frame comprises a top frame spring plug-in, and an inbuilt plug-in for mechanically connecting the top frame to the at least one lower top tube.

In certain embodiments, the at least one horizontal tube comprises at least one horizontal tube groove for mechanically connecting the at least one solar panel to the at least one horizontal tube, wherein particularly the at least one horizontal tube groove is positioned at both sides of the respective horizontal tube.

In certain embodiments, at least one side tube comprises at least one side tube groove for mechanically connecting the at least one solar panel to the at least one side tube, wherein particularly the at least one side tube groove is positioned at one side of the at least one side tube, and/ or a first side tube hole for mechanically connecting the at least one side tube to the at least one lower top tube.

In certain embodiments, the at least one solar panel comprises a first solar panel upright circuit connection device for electrically connecting the at least one solar panel to the battery box, and/ or a first solar panel hole for mechanically connecting the at least one solar panel to the at least one lower top tube.

In certain embodiments, the at least one lighting tube comprises a first lighting tube reverse side circuit connection device, which is electrically connected to the at least one lighting tube and the battery box, and/ or a first lighting tube hole for mechanically connecting the at least one lighting tube to a respective lower top tube, and/ or a side wings for mechanically connecting the at least one lighting tube to the top frame.

In certain embodiments, the ring beam comprises a first ring beam hole for mechanically connecting the respective ring beam to a respective lower top tube, and/ or a second hole for mechanically connecting the respective ring beam to a respective leg tube, a first ring beam upright circuit connection device, which is electrically connected to the temperature control device, particularly the cooling device, wherein the first ring beam upright circuit connection device is adapted to control the temperature control device, particularly the cooling device.

In certain embodiments, the at least one leg tube comprises a first leg tube hole for mechanically connecting the respective leg tube part to a respective ring beam, and/ or a second leg tube upright circuit connection device, which is electrically connected to the second lower top tube reverse side connection device, particularly on a respective lower top tube, and/ or a first leg tube reverse side connection device, which is electrically connected to the first ring beam upright circuit connection device, particularly of the cooling device.

The invention is further described by means of figures, from which further examples and embodiments can be drawn. The figures are not meant to limit the scope of the invention.

### Short description of the figures:

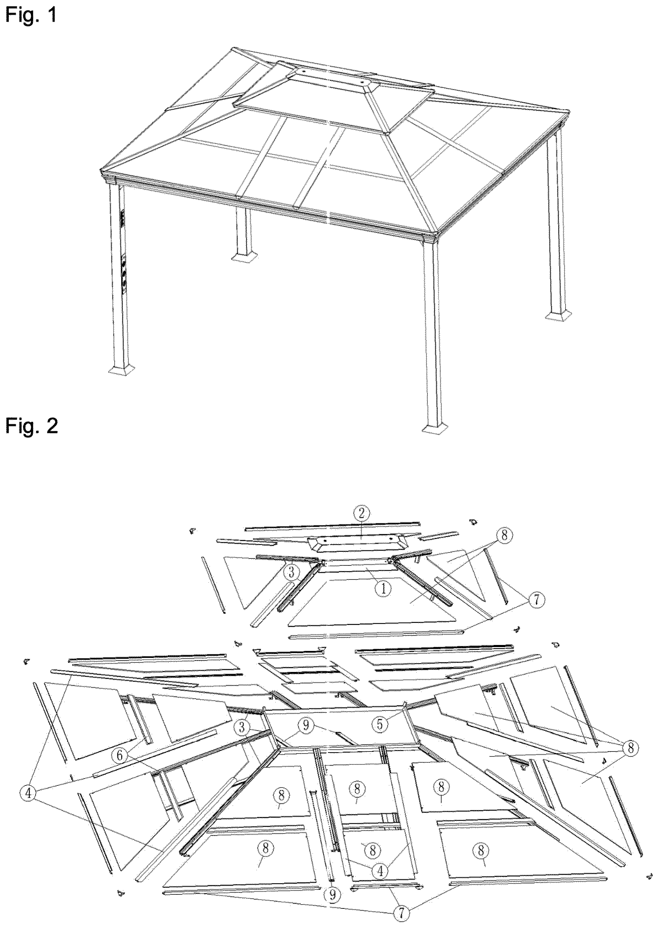

- Fig. 1: shows a solar tent's external view,
- Fig. 2: shows a solar tent's top part exploded view,

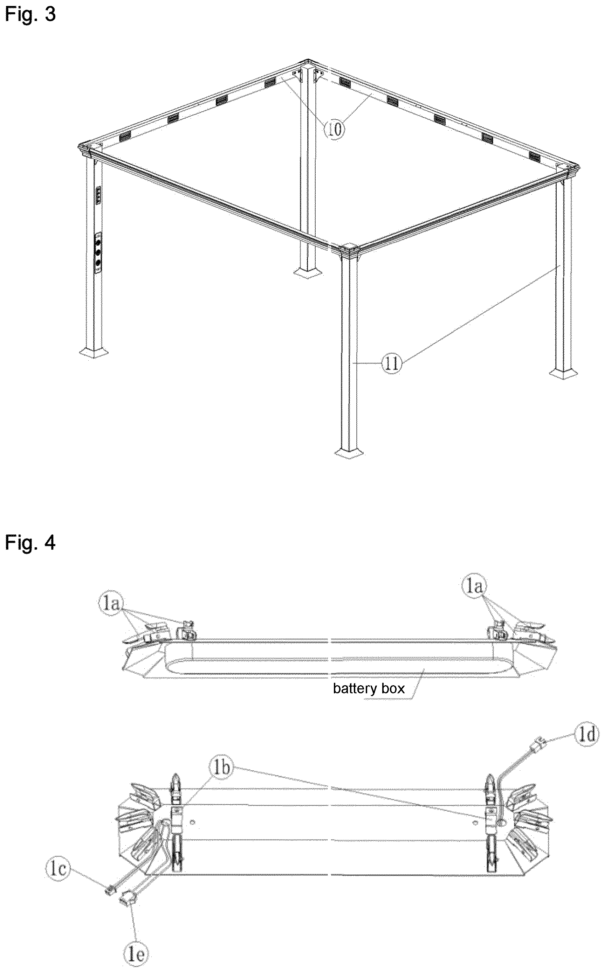

- Fig. 3: shows a solar tent's lower part structure diagram,

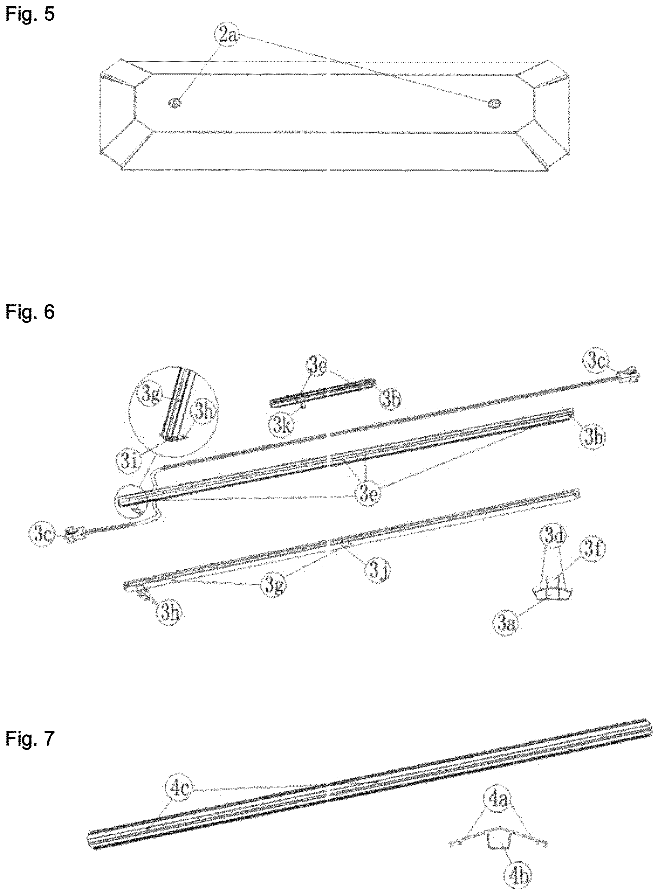

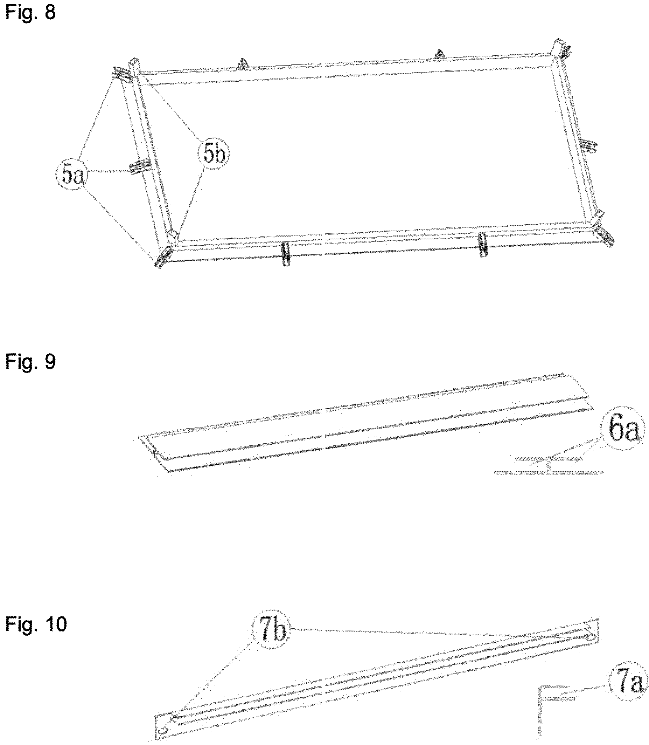

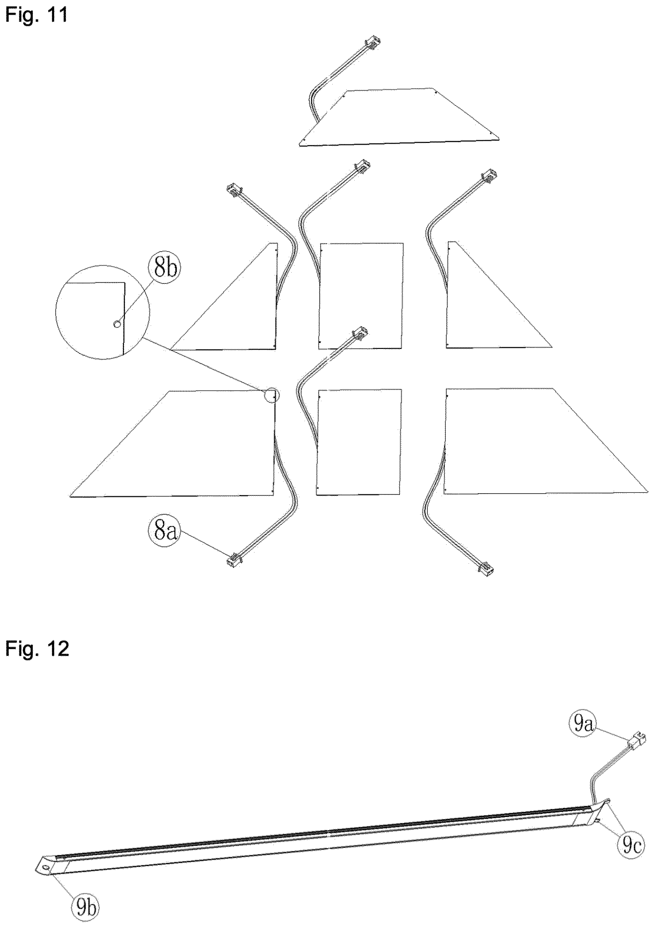

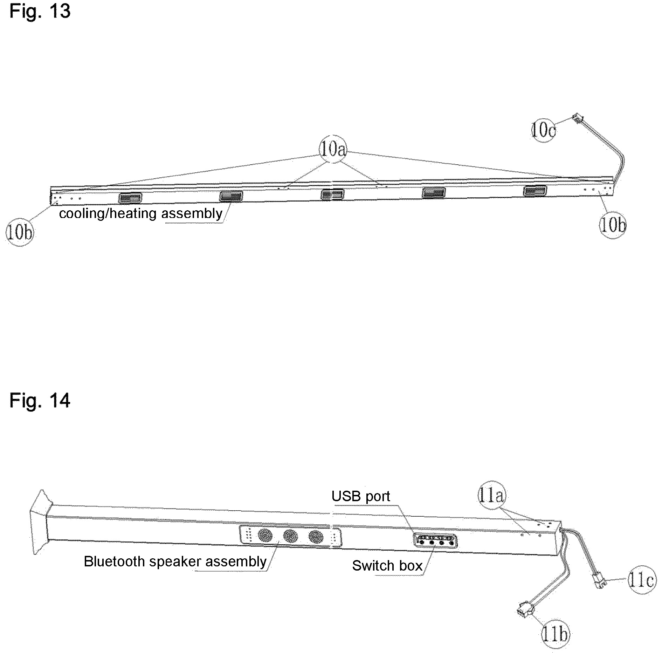

- Fig. 4 to Fig. 14: show schematic diagrams of different components

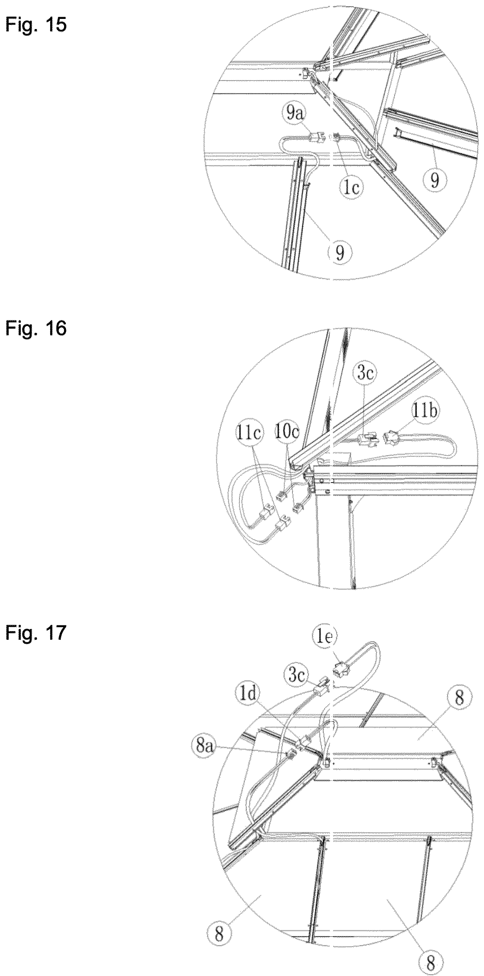

- Fig. 15 to Fig. 17: show a solar tent's circuit wiring diagram.

### Detailed description of the figures

The described battery box is fixed on the lower side of the lower top plate 1. The described Bluetooth speaker component and switch box are inserted in the leg tube 11. The described cooling component is inserted in the ring beam 10. The described heating component is inserted in the ring beam 10. The upper end of a number of the described leg tube parts 11 are each connected to the neighboring two ring beam parts 10 through a first leg tube hole 11a, and a second ring beam hole 10b and fixed with bolts.

A number of the described lower top tube parts 3 are fixed on the ring beam part 10 through a fourth hole 3h and a first ring beam hole 10a with the help of bolts.

A number of the described lower top tube parts 3 and the top frame 5 are fixed with a first lower tube 3a and the top frame spring plug-in 5a by insertion.

A number of the described lower top tube parts 3 and the top frame 5 are fixed with a second lower tube 3k and an inbuilt plug-in 5b by insertion.

A number of the described lower top tube parts 3 and lower top plate parts 1are fixed by means of the first lower tube 3a, the first lower top tube hole 3b and the lower top plate spring plug-in 1a by insertion.

A number of the described solar panels 8 are fixed to the lower top tubes 3 by means of a first solar panel hole 8b and a second lower top tube hole 3e with bolts, the two lengthways neighboring solar panels 8 are connected with the horizontal tubes 6 with the two side cards slot 6a, a number of the described side tubes 7 are fixed to the lower top tubes 3 by means of a first side tube hole 7b and a fifth hole 3i with bolts, and the card slot 7a surrounds the lower end of the solar panel 8.

The described upper top plate 2 is fixed to the lower top plat 1 by means of a first upper top plate hole 2a and a top plate connection device 1b with bolts, and surrounds the connection part of the lower top tube 3 and the lower top plate 1.

A number of the described upper top tube 4 are fixed to the lower top tube part 3 by means of a first upper top tube hole 4c and a third hole 3g with bolts.

A number of the described lighting tubes 9 are fixed to the lower top tubes 3 by means of a first lighting tube hole 9b and a sixth hole 3j with bolts.

A number of the described lighting tubes' 9 side wings 9c are fixed to the top frame 5.

The described solar panel 8 is connected to the lower top plate part 1 by means of a first solar panel upright circuit connection device 8a and a first top plate reverse side circuit connection device 1d in order to achieve power input from the solar panel 8 to the battery box. The described lower top plate part 1 is connected to the lighting tube 9 by means of a first top plate upright circuit connection device 1c and a first lighting tube reverse side circuit connection device 9a in order to achieve power output from the battery box to lighting tube 9. The described lower top plate part 1 is connected to the lower top tube part 3 through a second top plate upright connection device 1e and a second lower top tube reverse side connection device 3c. The lower top tube part 3 is connected to the leg tube part 11 the second lower top tube reverse side connection device 3c and a second leg tube upright circuit connection device 11b in order to achieve the connection from the battery box to the switchbox in order to control the switch of the circuit.

The described ring beam part 10 is connected to the leg tube part 11 by means of a first ring beam upright circuit connection device 10c and a first leg tube reverse side connection device 11c to achieve the power output and switch controls of the cooling and heating component.

Although this document has mainly applied terms such as : 1,lower top plate part ; 1a,spring plug-in ; 1b,top plate connection device ; 1c,circuit connection device (upright one) ; 1d,circuit connection device (reverse side one) ; 1e,circuit connection device (upright two) ; 2,upper top plate ; 2a,hole one ; 3,lower top tube part ; 3a, tube one ; 3b,hole one ; 3c,circuit connection device ( reverse side two) ; 3d,gutter ; 3e,hole two ; 3f,cable slot ; 3g,hole three ; 3h,hole four ; 3i,hole five ; 3j,hole six ; 3k, tube two ; 4,upper top tube ; 4a,side wings ; 4b, tube one ; 4c,hole one ; 5,top frame ; 5a,spring plug-in ; 5b,inbuilt plug-in ; 6,top horizontal tube ; 6a,card slot ; 7,side tube ; 7a,card slot ; 7b,hole one ; 8,solar panel ; 8a,circuit connection device (upright one) ; 8b,hole one ; 9,lighting tube ; 9a,circuit connection device (reverse side one) ; 9b,hole one ; 9c,side wings ; 10,ring beam part ; 10a,hole one ; 10b,hole two ; 10c,circuit connection device (upright one) ; 11,leg tube part ; 11a,hole one ; 11b,circuit connection device (upright two) ; 11c,circuit connection device (reverse side one) and other terms, it however does not rule out the possibility to apply other terms. These terms are merely used to describe and explain the nature of this invention; any attempt to regard them as an additional limitation goes against the fundamental concept of this invention.

**List of reference signs**

| | |
|---|---|
| Lower top plate | 1 |
| Lower top plate spring plug-in | 1a |
| Top plate connection device | 1b |
| First top plate upright circuit connection device | 1c |
| First top plate reverse side connection device | 1d |
| Second top plate upright connection device | 1e |
| Upper top plate | 2 |
| First upper top plate hole | 2a |
| Lower top tube | 3 |
| First lower tube | 3a |
| First lower top tube hole | 3b |
| Second lower top tube reverse side connection device | 3c |
| Gutter | 3d |
| Second lower top tube hole | 3e |
| Cable slot | 3f |
| Third hole | 3g |
| Fourth hole | 3h |
| Fifth hole | 3i |
| Sixth hole | 3j |
| Second lower tube | 3k |
| Upper top tube | 4 |
| Side wing | 4a |
| First tube | 4b |
| First upper top tube hole | 4c |
| Top frame | 5 |
| Top frame spring plug-in | 5a |
| Inbuilt plug-in | 5b |
| Horizontal tube | 6 |
| Horizontal tube groove, card slot | 6a |
| Side tube | 7 |
| Side tube groove, card slot | 7a |
| First side tube hole | 7b |
| Solar panel | 8 |
| First solar panel upright circuit connection device | 8a |
| First solar panel hole | 8b |
| Lighting tube | 9 |
| First lighting tube reverse side circuit connection device | 9a |
| First lighting tube hole | 9b |
| Side wings | 9c |
| Ring beam, ring beam part | 10 |
| First ring beam hole | 10a |
| Second ring beam hole | 10b |
| First ring beam upright circuit connection device | 10c |
| Leg tube, leg tube part | 11 |
| First leg tube hole | 11a |
| Second leg tube upright circuit connection device | 11b |
| First leg tube reverse side connection device | 11c |

## Claims

1. A solar tent comprising
• a plurality of ring beam parts (10), wherein the plurality of ring beam parts (10) is arranged such that the plurality of ring beam parts (10) forms a lower frame delimiting a first area,
• a plurality of leg tube parts (11), wherein the upper end of each leg tube part (11) is mechanically connected to two neighboring ring beam parts (10),
• a plurality of solar panels (8),
• a battery box, wherein the battery box is adapted to be charged by at least one solar panel (8) of the plurality of solar panels (8),
• a Bluetooth speaker component, which is comprised in at least one leg tube part (11) of the plurality of leg tube parts (11), wherein the Bluetooth speaker component is electrically connected to the at least one solar panel (8) and/ or the battery box, wherein the at least one solar panel (8) and/ or the battery box are adapted to provide electricity for operation of the Bluetooth speaker component,
• a switchbox, which is comprised in at least one leg tube part (11), wherein the switchbox is electrically connected to the battery box, and wherein the switchbox comprises a USB port, which is comprised in the switchbox,
• a temperature control device, wherein the temperature control device is comprised in at least one ring beam part (10) of the plurality of ring beam parts (10), and wherein the temperature control device is electrically connected to at least one solar panel (8) and/ or the battery box, wherein the at least one solar panel (8) and/ or the battery box are adapted to provide electricity for operation of the temperature control device,
• a top frame (5) delimiting a second area, wherein the second area is smaller than the first area,
• a lower top plate (1) and an upper top plate (2), which is mechanically connected the lower top plate (1), the lower frame, the top frame (5), the lower top plate (1) and the upper top plate (2) being in successive horizontal planes from the upper end of the leg tube parts (11) to the top of the solar tent,
• a plurality of lower top tubes (3), wherein some of the lower top tubes (3) mechanically connect the lower frame and the top frame (5), and other lower top tubes (3) mechanically connect the top frame (5) and the lower top plate (1),
• a plurality of upper top tube (4), wherein each upper top tube (4) of the plurality of upper top tubes (4) is mechanically connected to a corresponding lower top tube (3) of the plurality of lower top tubes (3), wherein each upper top tube (4) surrounds one side of a respective solar panel (8),
• a plurality of side tubes (7), wherein, amongst the plurality of side tubes (7), some are arranged at a ring beam part (10) between two neighbouring lower top tubes (3) and some others are arranged at the top frame (5) between two neighbouring lower top tubes (3),
• a plurality of horizontal tubes (6), wherein each of the the plurality of horizontal tubes (6) is arranged between two neighbouring lower top tubes (3) that connect the lower frame and the top frame (5),
wherein the lower top plate (1), the plurality of lower top tubes (3), the plurality of horizontal tubes (6) and the plurality of side tubes (7) form a supportive framework for each solar panel (8) of the plurality of solar panels (8),
wherein each solar panel (8) of the plurality of solar panels (8) is arranged between two neighbouring lower top tubes (3) such that the solar panel (8) is laterally mechanically connected with the two neighbouring lower top tubes (3), and
wherein each solar panel (8) of the plurality of solar panels (8) is arranged either:
between a the side tube (7) at the lower frame and a neighbouring horizontal tube (6), wherein the solar panel (8) is mechanically connected to the side tube (7) and the neighbouring horizontal tube (6), or
between a horizontal tube (6) and the top frame (5), wherein the solar panel (8) is mechanically connected to the horizontal tube (6), or
between a side tube (7) at the top frame (5) and the lower top plate (1), wherein the solar panel (8) is mechanically connected to the side tube (7) at the top frame (5),
• at least one lighting tube (9), which is mechanically connected to a lower top tube (3), and/ or to the top frame (5), and wherein the lighting tube (9) is electrically connected to the at least one solar panel (8) and/ or the battery box, wherein the at least one solar panel (8) and/ or the battery box are adapted to provide electricity for operation of the at least one lighting tube (9),
• wherein the battery box is comprised in the lower top plate (1).

2. The solar tent according to claim 1, **characterized in that** the lower top plate (1) comprises a lower top plate spring plug-in (1a) for mechanically connecting the lower top plate (1) to the at least one lower top tube (3) and/or the at least one upper top tube (4).

3. The solar tent according to claim 1 or 2, **characterized in that** the lower top plate (1) comprises a top plate connection device (1b) for mechanically connecting the lower top plate (1) to the upper top plate (2).

4. The solar tent according to one of the preceding claims, **characterized in that** the lower top plate (1) comprises
• a first top plate upright circuit connection device (1c), which is adapted to be electrically connected to the at least one lighting tube (9), and/ or
• a first top plate reverse side connection device (1d), which is adapted to be electrically connected to the at least one solar panel (8), and/ or
• a second top plate upright connection device (1e).

5. The solar tent according to one of the preceding claims, **characterized in that** the upper top plate (2) comprises a first upper top plate hole (2a) for mechanically connecting the upper top plate (2) to the lower top plate (1).

6. The solar tent according to one of the preceding claims, **characterized in that** each of the plurality of lower top tubes (3) comprises
• a gutter (3d) comprising a second hole (3e) for mechanically connecting a respective solar panel (8) to the gutter (3d) and/ or
• a cable slot (3f) comprising a third hole (3g) for mechanically connecting a respective upper top tube (4) to the cable slot (3f), and/ or a circuit for electrically connecting the battery box to the switchbox, wherein the circuit comprises at least one second lower top tube reverse side connection device (3c), and/ or
• a fourth hole (3h) for mechanically connecting the lower top tube (3) to a respective ring beam (10), and/ or
• a fifth hole (3i) for mechanically connecting the lower top tube (3) to a respective side tube (7), and/ or
• a sixth hole (3j) for mechanically connecting the lower top tube (3) to the at least one lighting tube (9).

7. The solar tent according to one of the preceding claims, **characterized in that** each of the plurality of upper top tubes (4) comprises at least one side wing (4a), which is adapted to cover a respective lower top tube (3).

8. The solar tent according to one of the preceding claims, **characterized in that** each of the plurality of upper top tubes (4) comprises a first tube (4b), for mechanically connecting the upper top tube (4) to the lower top plate (1), wherein the first tube (4b) comprises a first upper top tube hole (4c) for mechanically connecting the upper top tube (4) to the lower top tube (3).

9. The solar tent according to one of the preceding claims, **characterized in that** the top frame (5) comprises a top frame spring plug-in (5a), and an inbuilt plug-in (5b) for mechanically connecting the top frame (5) to a respective lower top tube (3).

10. The solar tent according to one of the preceding claims, **characterized in that** each of the plurality of horizontal tubes (6) comprises at least one horizontal tube groove (6a) for mechanically connecting a respective solar panel (8) to the horizontal tube (6).

11. The solar tent according to one of the preceding claims, **characterized in that** each of the plurality of side tubes (7) comprises
• at least one side tube groove (7a) for mechanically connecting a respective solar panel (8) to the side tube (7), and/ or
• a first side tube hole (7b) for mechanically connecting the side tube (7) to a respective lower top tube (3).

12. The solar tent according to one of the preceding claims, **characterized in that** each of the plurality of solar panels (8) comprises
• a first solar panel upright circuit connection device (8a) for electrically connecting the solar panel (8) to the battery box, and/ or
• a first solar panel hole (8b) for mechanically connecting the at least one solar panel (8) to a respective lower top tube (3).

13. The solar tent according to one of the preceding claims, **characterized in that** the at least one lighting tube (9) comprises
• a first lighting tube reverse side circuit connection device (9a), which is electrically connected to the at least one lighting tube (9) and the battery box, and/ or
• a first lighting tube hole (9b) for mechanically connecting the at least one lighting tube (9) to a respective lower top tube (3), and/ or
• a side wings (9c) for mechanically connecting the at least one lighting tube (9) to the top frame (5).

14. The solar tent according to one of the preceding claims, **characterized in that** each of the plurality of ring beam parts (10) comprises
• a first ring beam hole (10a) for mechanically connecting the respective ring beam (10) part to a respective lower top tube (3), and/ or
• a second hole (10b) for mechanically connecting the respective ring beam part (10) to a respective leg tube (11),
• a first ring beam upright circuit connection device (10c), which is electrically connected to the temperature control device, wherein the first ring beam upright circuit connection device (10c) is adapted to control the temperature control device.

15. The solar tent according to one of the preceding claims, **characterized in that** each of the plurality of leg tube parts (11) comprises
• a first leg tube hole (11a) for mechanically connecting the respective leg tube part (11) to a respective ring beam part (10), and/ or
• a second leg tube upright circuit connection device (11b), which is electrically connected to the second lower top tube reverse side connection device (3c), and/ or
• a first leg tube reverse side connection device (11c), which is electrically connected to the first ring beam upright circuit connection device (10c).

## Patentansprüche

1. Ein Solarzelt, bestehend aus
• einer Vielzahl von Ringbalkenelementen (10), wobei die Vielzahl von Ringbalkenelementen (10) so angeordnet ist, dass die Vielzahl von Ringbalkenelementen (10) einen unteren Rahmen bildet, der einen ersten Bereich begrenzt,
• einer Vielzahl von Beinrohrelementen (11), wobei das obere Ende jedes Beinrohrelements (11) mechanisch mit zwei benachbarten Ringbalkenelementen (10) verbunden ist,
• einer Vielzahl von Solarmodulen (8),
• einem Batteriekasten, wobei der Batteriekasten so ausgelegt ist, dass er durch mindestens ein Solarmodul (8) der Vielzahl von Solarmodulen (8) aufgeladen wird,
• eine Bluetooth-Lautsprecherkomponente, die in mindestens einem Beinrohrelement (11) der mehreren Beinrohrelemente (11) enthalten ist, wobei die Bluetooth-Lautsprecherkomponente elektrisch mit dem mindestens einen Solarmodul (8) und/oder dem Batteriekasten verbunden ist, wobei das mindestens eine Solarmodul (8) und/oder der Batteriekasten dazu ausgelegt sind Strom für den Betrieb der Bluetooth-Lautsprecherkomponente bereitzustellen,
• ein Schaltkasten, der in mindestens einem Beinrohrelement (11) enthalten ist, wobei der Schaltkasten elektrisch mit dem Batteriekasten verbunden ist und wobei der Schaltkasten einen USB-Anschluss umfasst, der in dem Schaltkasten enthalten ist,
• eine Temperaturregelungsvorrichtung, wobei die Temperaturregelungsvorrichtung in mindestens einem Ringbalkenelement (10) der Vielzahl von Ringbalkenelementen (10) enthalten ist und wobei die Temperaturregelungsvorrichtung elektrisch mit mindestens einem Solarmodul (8) und/oder dem Batteriekasten verbunden ist, wobei das mindestens eine Solarmodul (8) und/oder der Batteriekasten dazu ausgelegt sind, Strom für den Betrieb der Temperaturregelungsvorrichtung bereitzustellen,
• ein oberer Rahmen (5), der einen zweiten Bereich begrenzt, wobei der zweite Bereich kleiner ist als der erste Bereich,
• eine untere Deckplatte (1) und eine obere Deckplatte (2), die mechanisch mit der unteren Deckplatte (1) verbunden ist, wobei der untere Rahmen, der obere Rahmen (5), die untere Deckplatte (1) und die obere Deckplatte (2) in aufeinanderfolgenden horizontalen Ebenen vom oberen Ende der Beinrohrelemente (11) bis zur Oberseite des Solarzeltes angeordnet sind,
• eine Vielzahl von unteren Oberrohren (3), wobei einige der unteren Oberrohre (3) den unteren Rahmen und den oberen Rahmen (5) mechanisch verbinden und andere untere Oberrohre (3) den oberen Rahmen (5) und die untere Deckplatte (1) mechanisch verbinden,
• eine Vielzahl von oberen Oberrohren (4), wobei jedes obere Oberrohr (4) der Vielzahl von oberen Oberrohren (4) mechanisch mit einem entsprechenden unteren Oberrohr (3) der Vielzahl von unteren Oberrohren (3) verbunden ist, wobei jedes obere Oberrohr (4) eine Seite eines jeweiligen Solarmoduls (8) umgibt,
• eine Vielzahl von Seitenrohren (7), wobei einige der Vielzahl von Seitenrohren (7) an einem Ringbalkenelement (10) zwischen zwei benachbarten unteren Oberrohren (3) angeordnet sind und einige andere am oberen Rahmen (5) zwischen zwei benachbarten unteren Oberrohren (3) angeordnet sind,
• eine Vielzahl von horizontalen Rohren (6), wobei jedes der Vielzahl von horizontalen Rohren (6) zwischen zwei benachbarten unteren Oberrohren (3) angeordnet ist, die den unteren Rahmen und den oberen Rahmen (5) verbinden,
wobei die untere Deckpatte (1), die Vielzahl von unteren Oberrohren (3), die Vielzahl von horizontalen Rohren (6) und die Vielzahl von Seitenrohren (7) ein Stützgerüst für jedes Solarmodul (8) der Vielzahl von Solarmodulen (8) bilden,
wobei jedes Solarmodul (8) der Vielzahl von Solarmodulen (8) zwischen zwei benachbarten unteren Oberrohren (3) angeordnet ist, sodass das Solarmodul (8) seitlich mechanisch mit den beiden benachbarten unteren Oberrohren (3) verbunden ist, und
wobei jedes Solarmodul (8) der Vielzahl von Solarmodulen (8) entweder:
zwischen einem Seitenrohr (7) am unteren Rahmen und einem benachbarten horizontalen Rohr (6), wobei das Solarmodul (8) mechanisch mit dem Seitenrohr (7) und dem benachbarten horizontalen Rohr (6) verbunden ist, oder
zwischen einem horizontalen Rohr (6) und dem oberen Rahmen (5), wobei das Solarmodul (8) mechanisch mit dem horizontalen Rohr (6) verbunden ist, oder
zwischen einem Seitenrohr (7) am oberen Rahmen (5) und der unteren Deckplatte (1), wobei das Solarmodul (8) mechanisch mit dem Seitenrohr (7) am oberen Rahmen (5) verbunden ist,
• mindestens ein Leuchtrohr (9), das mechanisch mit einem unteren Oberrohr (3) und/oder mit dem oberen Rahmen (5) verbunden ist, und wobei das Leuchtrohr (9) elektrisch mit dem mindestens einen Solarmodul (8) und/oder dem Batteriekasten verbunden ist, wobei das mindestens eine Solarmodul (8) und/oder der Batteriekasten dazu ausgelegt sind, Strom für den Betrieb des mindestens einen Leuchtrohr (9) bereitzustellen,
• wobei der Batteriekasten in der unteren Deckplatte (1) enthalten ist.

2. Das Solarzelt gemäß Anspruch 1, **dadurch gekennzeichnet, dass** die untere Deckplatte (1) einen unteren Dachplatten-Federstecker (1a) umfasst, um die untere Deckplatte (1) mechanisch mit dem mindestens einen unteren Oberrohr (3) und/oder dem mindestens einen oberen Oberrohr (4) zu verbinden.

3. Das Solarzelt gemäß Anspruch 1 oder 2, **dadurch gekennzeichnet, dass** die untere Deckplatte (1) eine Deckplatten-Verbindungsvorrichtung (1b) zum mechanischen Verbinden der unteren Deckplatte (1) mit der oberen Deckplatte (2) umfasst.

4. Das Solarzelt gemäß einem der vorhergehenden Ansprüche, **dadurch gekennzeichnet, dass** die untere Deckplatte (1)
• eine erste senkrechte obere Deckplatten-Schaltverbindungsvorrichtung (1c), die dazu ausgelegt ist, elektrisch mit dem mindestens einem Leuchtrohr (9) verbunden zu werden, und/oder
• eine erste rückseitige obere Deckplatten-Schaltverbindungsvorrichtung (1d), die dazu ausgelegt ist, elektrisch mit dem mindestens einen Solarmodul (8) verbunden zu werden, und/oder eine zweite senkrechte obere Deckplatten-Verbindungsvorrichtung (1e) für die obere Deckplatte,
umfasst.

5. Das Solarzelt gemäß einem der vorhergehenden Ansprüche, **dadurch gekennzeichnet, dass** die obere Deckplatte (2) ein erstes Loch (2a) in der oberen Deckplatte aufweist, um die obere Deckplatte (2) mechanisch mit der unteren Deckplatte (1) zu verbinden.

6. Das Solarzelt gemäß einem der vorhergehenden Ansprüche, **dadurch gekennzeichnet, dass** jedes der Vielzahl von unteren Oberrohren (3)
• eine Regenrinne (3d) mit einem zweiten Loch (3d) zum mechanischen Verbinden eines jeweiligen Solarmoduls (8) mit der Regenrinne (3d) und/oder
• einen Kabelschlitz (3f) mit einem dritten Loch (3g) zum mechanischen Verbinden eines entsprechenden oberen Oberrohrs (4) mit dem Kabelschlitz (3f) und/oder eine Schaltung zum elektrischen Verbinden des Batteriekastens mit dem Schaltkasten, wobei die Schaltung mindestens eine zweite Verbindungseinrichtung (3c) für die Rückseite des unteren Oberrohrs und/oder
• ein viertes Loch (3h) zum mechanischen Verbinden des unteren Oberrohrs (3) mit einem jeweiligen Ringbalken (10) und/oder
• ein fünftes Loch (3i) zum mechanischen Verbinden des unteren Oberrohrs (3) mit einem entsprechenden Seitenrohr (7) und/oder
• ein sechstes Loch (3j) zum mechanischen Verbinden des unteren Oberrohrs (3) mit dem mindestens einen Leuchtrohr (9)
umfasst.

7. Das Solarzelt gemäß einem der vorhergehenden Ansprüche, **dadurch gekennzeichnet, dass** jedes der Vielzahl von oberen Oberrohren (4) mindestens einen Seitenflügel (4a) umfasst, der dazu ausgelegt ist, ein jeweiliges unteres Oberrohr (3) abzudecken.

8. Das Solarzelt gemäß einem der vorhergehenden Ansprüche, **dadurch gekennzeichnet, dass** jedes der Vielzahl von oberen Oberrohren (4) ein erstes Rohrstück (4b) umfasst, um das obere Oberrohr (4) mechanisch mit der unteren Deckplatte (1) zu verbinden, wobei das erste Rohrstück (4b) ein erstes Oberrohr-Loch (4c) umfasst, um das obere Oberrohr (4) mechanisch mit dem unteren Oberrohr (3) zu verbinden.

9. Das Solarzelt gemäß einem der vorhergehenden Ansprüche, **dadurch gekennzeichnet, dass** der obere Rahmen (5) einen oberen Rahmen-Federstecker (5a) und einen eingebauten Stecker (5b) zum mechanischen Verbinden des oberen Rahmens (5) mit einem entsprechenden unteren Oberrohr (3) umfasst.

10. Das Solarzelt gemäß einem der vorhergehenden Ansprüche, **dadurch gekennzeichnet, dass** jedes der Vielzahl von horizontalen Rohren (6) mindestens eine horizontale Rohr-Nut (6a) aufweist, um ein jeweiliges Solarmodul (8) mechanisch mit dem horizontalen Rohr (6) zu verbinden.

11. Das Solarzelt gemäß einem der vorhergehenden Ansprüche, **dadurch gekennzeichnet, dass** jedes der Vielzahl von Seitenrohren (7)
• mindestens eine Seitenrohr-Nut (7a) zum mechanischen Verbinden eines jeweiligen Solarmoduls (8) mit dem Seitenrohr (7) und/oder
• ein erstes Seitenrohr-Loch (7b) zum mechanischen Verbinden des Seitenrohrs (7) mit einem jeweiligen unteren Oberrohr (3)
umfasst.

12. Das Solarzelt gemäß einem der vorhergehenden Ansprüche, **dadurch gekennzeichnet, dass** jedes der Vielzahl von Solarmodulen (8)
• eine erste senkrechte Solarmodul-Schaltverbindungsvorrichtung (8a) zum elektrischen Verbinden des Solarmoduls (8) mit dem Batteriekasten und/oder
• ein erstes Solarmodul-Loch (8b) zum mechanischen Verbinden des mindestens einen Solarmodul (8) mit einem entsprechenden unteren Oberrohr (3)
umfasst.

13. Das Solarzelt gemäß einem der vorhergehenden Ansprüche, **dadurch gekennzeichnet, dass** die mindestens eine Leuchtröhre (9)
• eine erste rückseitige Leuchtrohr-Schaltverbindungsvorrichtung (9a), die elektrisch mit der mindestens einen Leuchtröhre (9) und dem Batteriekasten verbunden ist, und/oder
• ein erstes Leuchtrohr- Loch (9b) zum mechanischen Verbinden des mindestens einen Leuchtrohrs (9) mit einem jeweiligen unteren Oberrohr (3), und/oder
• einen Seitenflügel (9c) zum mechanischen Verbinden des mindestens einen Leuchtrohrs (9) mit dem Oberrahmen (5)
umfasst.

14. Das Solarzelt gemäß einem der vorhergehenden Ansprüche, **dadurch gekennzeichnet, dass** jedes der Vielzahl von Ringbalkenelementen (10)
• ein erstes Ringbalkenelement-Loch (10a) zum mechanischen Verbinden des jeweiligen Ringbalkens (10) mit einem jeweiligen unteren Oberrohr (3) und/oder
• ein zweites Loch (10b) zum mechanischen Verbinden des jeweiligen Ringbalkens (10) mit einem jeweiligen Beinrohrelement (11),
• eine erste senkrechte Ringbalken-Schaltverbindungsvorrichtung (10c), die elektrisch mit der Temperaturregelungsvorrichtung verbunden ist, wobei die erste senkrechte Ringbalken-Schaltverbindungsvorrichtung (10c) dazu ausgelegt ist, die Temperaturregelungsvorrichtung zu steuern
umfasst.

15. Das Solarzelt gemäß einem der vorhergehenden Ansprüche, **dadurch gekennzeichnet, dass** jedes der Vielzahl von Beinrohrelementen (11)
• ein erstes Beinrohr-Loch (11a) zum mechanischen Verbinden des jeweiligen Beinrohrelements (11) mit einem jeweiligen Ringbalkenelement (10) und/oder
• eine zweite senkrechte Beinrohr-Schaltverbindungsvorrichtung (11b), die elektrisch mit der zweiten rückseitigen Oberrohr-Schaltverbindungsvorrichtung (3c) verbunden ist, und/oder
• eine erste rückseitige Beinrohr-Schaltverbindungsvorrichtung (11c), die elektrisch mit der ersten senkrechten Ringbalken-Schaltverbindungsvorrichtung (10c) verbunden ist
umfasst.

## Revendications

1. Tente solaire comprenant
• une pluralité de parties de poudre annulaire (10), dans laquelle la pluralité de parties de poutre annulaire (10) est agencée de sorte que la pluralité de parties de poutre annulaire (10) forme un cadre inférieur délimitant une première zone,
• une pluralité de parties de tube de jambe (11), dans laquelle l'extrémité supérieure de chaque partie de tube de jambe (11) est connectée mécaniquement à deux parties de poutre annulaire voisines (10),
• une pluralité de panneaux solaires (8),
• un boîtier de batterie, dans laquelle le boîtier de batterie est adapté à être chargé par au moins un panneau solaire (8) de la pluralité de panneaux solaires (8),
• un composant de haut-parleur Bluetooth, qui est compris dans au moins une partie de tube de jambe (11) de la pluralité de parties de tube de jambe (11), dans laquelle le composant de haut-parleur Bluetooth est connecté électriquement à au moins un panneau solaire (8) et/ou au boîtier de batterie, dans laquelle l'au moins un panneau solaire (8) et/ou le boîtier de batterie sont adaptés à fournir de l'électricité pour l'opération du composant de haut-parleur Bluetooth,
• une boîte de distribution, qui est comprise dans au moins une partie de tube de jambe (11), dans laquelle la boîte de distribution est connectée électriquement au boîtier de batterie, et dans laquelle la boîte de distribution comprend un port USB, qui est compris dans la boîte de distribution,
• un dispositif de commande de température, dans laquelle le dispositif de commande de température est compris dans au moins une partie de poutre annulaire (10) de la pluralité de parties de poutre annulaire (10), et dans laquelle le dispositif de commande de température est connecté électriquement à au moins un panneau solaire (8) et/ou au boîtier de batterie, dans laquelle l'au moins un panneau solaire (8) et/ou le boîtier de batterie sont adaptés à fournir de l'électricité pour l'opération du dispositif de commande de température,
• un cadre supérieur (5) délimitant une seconde zone, dans laquelle la seconde zone est inférieure à la première zone,
• une plaque de dessus inférieure (1) et une plaque de dessus supérieure (2), qui est connectée mécaniquement à la plaque de dessus inférieure (1), au cadre inférieur, au cadre supérieur (5), la plaque de dessus inférieure (1) et la plaque de dessus supérieure (2) étant dans des plans horizontaux successifs de l'extrémité supérieure des parties de tube de jambe (11) au dessus de la tente solaire,
• une pluralité de tubes de dessus inférieurs (3), dans laquelle certains des tubes de dessus inférieurs (3) connectent mécaniquement le cadre inférieur et le cadre supérieur (5), et d'autres tubes de dessus inférieurs (3) connectent mécaniquement le cadre supérieur (5) et la plaque de dessus inférieure (1),
• une pluralité de tubes de dessus supérieurs (4), dans laquelle chaque tube de dessus supérieur (4) de la pluralité de tubes de dessus supérieurs (4) est connecté mécaniquement à un tube de dessus inférieur correspondant (3) de la pluralité de tubes de dessus inférieurs (3), dans laquelle chaque tube de dessus supérieur (4) entoure un côté d'un panneau solaire respectif (8),
• une pluralité de tubes latéraux (7), dans laquelle, parmi la pluralité de tubes latéraux (7), certains sont agencés au niveau d'une partie de poutre annulaire (10) entre deux tubes de dessus inférieurs voisins (3) et certains autres sont agencés au niveau du cadre supérieur (5) entre deux tubes de dessus inférieurs voisins (3),
• une pluralité de tubes horizontaux (6), dans laquelle chacun de la pluralité de tubes horizontaux (6) est agencé entre deux tubes de dessus inférieurs voisins (3) qui connectent le cadre inférieur et le cadre supérieur (5),
dans laquelle la plaque de dessus inférieure (1), la pluralité de tubes de dessus inférieurs (3), la pluralité de tubes horizontaux (6) et la pluralité de tubes latéraux (7) forment une structure de support pour chaque panneau solaire (8) de la pluralité de panneaux solaires (8),
dans laquelle chaque panneau solaire (8) de la pluralité de panneaux solaires (8) est agencé entre deux tubes de dessus inférieurs voisins (3) de sorte que le panneau solaire (8) est connecté mécaniquement latéralement aux deux tubes de dessus inférieurs voisins (3), et
dans laquelle chaque panneau solaire (8) de la pluralité de panneaux solaires (8) est agencé soit :
entre un tube latéral (7) au niveau du cadre inférieur et un tube horizontal voisin (6), dans laquelle le panneau solaire (8) est connecté mécaniquement au tube latéral (7) et au tube horizontal voisin (6), soit
entre un tube horizontal (6) et le cadre supérieur (5), dans laquelle le panneau solaire (8) est connecté mécaniquement au tube horizontal (6), soit
entre un tube latéral (7) au niveau du cadre supérieur (5) et la plaque de dessus inférieure (1), dans laquelle le panneau solaire (8) est connecté mécaniquement au tube latéral (7) au niveau du cadre supérieur (5),
• au moins un tube d'éclairage (9), qui est connecté mécaniquement à un tube de dessus inférieur (3) et/ou au cadre supérieur (5), et
dans laquelle le tube d'éclairage (9) est connecté électriquement à l'au moins un panneau solaire (8) et/ou au boîtier de batterie, dans laquelle l'au moins un panneau solaire (8) et/ou le boîtier de batterie sont adaptés à fournir de l'électricité pour l'opération de l'au moins un tube d'éclairage (9),
• dans laquelle le boîtier de batterie est compris dans la plaque de dessus inférieure (1).

2. Tente solaire selon la revendication 1, **caractérisée en ce que** la plaque de dessus inférieure (1) comprend un élément enfichable à ressort de plaque de dessus inférieure (1a) pour connecter mécaniquement la plaque de dessus inférieure (1) à l'au moins un tube de dessus inférieur (3) et/ou l'au moins un tube de dessus supérieur (4).

3. Tente solaire selon la revendication 1 ou 2, **caractérisée en ce que** la plaque de dessus inférieure (1) comprend un dispositif de connexion de plaque de dessus (1b) pour connecter mécaniquement la plaque de dessus inférieure (1) à la plaque de dessus supérieure (2).

4. Tente solaire selon une des revendications précédentes, **caractérisée en ce que** la plaque de dessus inférieure (1) comprend
• un premier dispositif de connexion de circuit vertical de plaque de dessus (1c), qui est adapté à être connecté électriquement à l'au moins un tube d'éclairage (9), et/ou
• un premier dispositif de connexion de côté inverse de plaque de dessus (1d), qui est adapté à être connecté électriquement à l'au moins un panneau solaire (8), et/ou
• un second dispositif de connexion vertical de plaque de dessus (1e).

5. Tente solaire selon une des revendications précédentes, **caractérisée en ce que** la plaque de dessus supérieure (2) comprend un premier orifice de plaque de dessus supérieure (2a) pour connecter mécaniquement la plaque de dessus supérieure (2) à la plaque de dessus inférieure (1).

6. Tente solaire selon une des revendications précédentes, **caractérisée en ce que** chacun de la pluralité de tubes de dessus inférieurs (3) comprend
• une gouttière (3d) comprenant un deuxième orifice (3e) pour connecter mécaniquement un panneau solaire respectif (8) à la gouttière (3d) et/ou
• un passe-câble (3f) comprenant un troisième orifice (3g) pour connecter mécaniquement un tube de dessus supérieur respectif (4) au passe-câble (3f), et/ou un circuit pour connecter électriquement le boîtier de batterie à la boîte de distribution, dans laquelle le circuit comprend au moins un second dispositif de connexion de côté inverse de tube de dessus inférieur (3c), et/ou
• un quatrième orifice (3h) pour connecter mécaniquement le tube de dessus inférieur (3) à une poutre annulaire respective (10), et/ou
• un cinquième orifice (3i) pour connecter mécaniquement le tube de dessus inférieur (3) à un tube latéral respectif (7), et/ou
• un sixième orifice (3j) pour connecter mécaniquement le tube de dessus inférieur (3) à l'au moins un tube d'éclairage (9).

7. Tente solaire selon une des revendications précédentes, **caractérisée en ce que** chacun de la pluralité de tubes de dessus supérieurs (4) comprend au moins une aile latérale (4a), qui est adaptée à couvrir un tube de dessus inférieur respectif (3).

8. Tente solaire selon une des revendications précédentes, **caractérisée en ce que** chacun de la pluralité de tubes de dessus supérieurs (4) comprend un premier tube (4b), pour connecter mécaniquement le tube de dessus supérieur (4) à la plaque de dessus inférieure (1), dans laquelle le premier tube (4b) comprend un premier orifice de tube de dessus supérieur (4c) pour connecter mécaniquement le tube de dessus supérieur (4) au tube de dessus inférieur (3).

9. Tente solaire selon une des revendications précédentes, **caractérisée en ce que** le cadre supérieur (5) comprend un élément enfichable à ressort de cadre supérieur (5a), et un élément enfichable encastré (5b) pour connecter mécaniquement le cadre supérieur (5) à un tube de dessus inférieur respectif (3).

10. Tente solaire selon une des revendications précédentes, **caractérisée en ce que** chacun de la pluralité de tubes horizontaux (6) comprend au moins une rainure de tube horizontal (6a) pour connecter mécaniquement un panneau solaire respectif (8) au tube horizontal (6).

11. Tente solaire selon une des revendications précédentes, **caractérisée en ce que** chacun de la pluralité de tubes latéraux (7) comprend
• au moins une rainure de tube latéral (7a) pour connecter mécaniquement un panneau solaire respectif (8) au tube latéral (7), et/ou
• un premier orifice de tube latéral (7b) pour connecter mécaniquement le tube latéral (7) à un tube de dessus inférieur respectif (3).

12. Tente solaire selon une des revendications précédentes, **caractérisée en ce que** chacun de la pluralité de panneaux solaires (8) comprend
• un premier dispositif de connexion de circuit vertical de panneau solaire (8a) pour connecter électriquement le panneau solaire (8) au boîtier de batterie, et/ou
• un premier orifice de panneau solaire (8b) pour connecter mécaniquement le panneau solaire (8) à un tube de dessus inférieur respectif (3).

13. Tente solaire selon une des revendications précédentes, **caractérisée en ce que** l'au moins un tube d'éclairage (9) comprend
• un premier dispositif de connexion de circuit de côté inverse de tube d'éclairage (9a), qui est connecté électriquement à l'au moins un tube d'éclairage (9) et au boîtier de batterie, et/ou
• un premier orifice de tube d'éclairage (9b) pour connecter mécaniquement l'au moins un tube d'éclairage (9) à un tube de dessus inférieur respectif (3), et/ou
• une aile latérale (9c) pour connecter mécaniquement l'au moins un tube d'éclairage (9) au cadre supérieur (5).

14. Tente solaire selon une des revendications précédentes, **caractérisée en ce que** chacune de la pluralité de parties de poutre annulaire (10) comprend
• un premier orifice de poutre annulaire (10a) pour connecter mécaniquement la partie de poutre annulaire respective (10) à un tube de dessus inférieur respectif (3), et/ou
• un deuxième orifice (10b) pour connecter mécaniquement la partie de poutre annulaire respective (10) à un tube de jambe respectif (11),
• un premier dispositif de connexion de circuit vertical de poutre annulaire (10c), qui est connecté électriquement au dispositif de commande de température, dans laquelle le premier dispositif de connexion de circuit vertical de poutre annulaire (10c) est adapté à commander le dispositif de commande de température.

15. Tente solaire selon une des revendications précédentes, **caractérisée en ce que** chacune de la pluralité de parties de tube de jambe (11) comprend
• un premier orifice de tube de jambe (11a) pour connecter mécaniquement la partie de tube de jambe respective (11) à une partie de poutre annulaire respective (10), et/ou
• un second dispositif de connexion de circuit vertical de tube de jambe (11b), qui est connecté électriquement au second dispositif de connexion de côté inverse de tube de dessus inférieur (3c), et/ou
• un premier dispositif de connexion de côté inverse de tube de jambe (11c), qui est connecté électriquement au premier dispositif de connexion de circuit vertical de poutre annulaire (10c).
